# EUROPÄISCHE PATENTSCHRIFT

(11) **EP 2 342 958 B1**
(45) Veröffentlichungstag und Bekanntmachung des Hinweises auf die Patenterteilung: **17.06.2020**
(21) Anmeldenummer: 09748690.6
(22) Anmeldetag: 28.10.2009
(51) Int. Cl.: H01L 23/544, H01L 21/683, H01L 23/538, H01L 23/00, H05K 1/18, H01L 21/60, H01L 21/58, H05K 3/00, H05K 3/02, H05K 3/30

(54) **VERFAHREN ZUR INTEGRATION EINES ELEKTRONISCHEN BAUTEILS IN EINE LEITERPLATTE**
METHOD FOR INTEGRATING AN ELECTRONIC COMPONENT INTO A PRINTED CIRCUIT BOARD
PROCÉDÉ D'INTÉGRATION D'UN COMPOSANT ÉLECTRONIQUE DANS UNE CARTE IMPRIMÉE

(30) Priorität: 30.10.2008 AT 61908 U; 25.08.2009 AT 52909 U
(43) Veröffentlichungstag der Anmeldung: 13.07.2011
(73) Patentinhaber: AT & S Austria Technologie & Systemtechnik Aktiengesellschaft, 8700 Leoben-Hinterberg (AT)
(72) Erfinder: SCHRITTWIESER, Wolfgang, A-8605 Kapfenberg (AT); LENHARDT, Patrick, A-8724 Spielberg bei Knittelfeld (AT); MERL, Klaus, A-8600 Bruck/Mur (AT)
(74) Vertreter: Miksovsky, Alexander
(86) Internationale Anmeldenummer: PCT/AT2009/000418
(87) Internationale Veröffentlichungsnummer: WO 2010/048653

(56) Entgegenhaltungen:
- WO-A1-00/57680
- WO-A1-2005/104636
- FR-A1- 2 822 338
- TW-B- 429 735
- US-A- 6 119 335
- US-A1- 2005 253 244
- US-A1- 2006 278 967
- US-A1- 2008 067 666
- HESSLING M ET AL: "PRAEZISE LOECHER LASERBOHREN VON MIKROVIAS IN LEITERPLATTEN", LASER PRAXIS, CARL HANSER VERLAG, MUENCHEN, DE, Nr. 3, 1. Oktober 2001 (2001-10-01), Seiten 14-16, XP001101990, ISSN: 0937-7069

## Beschreibung

Die vorliegende Erfindung bezieht sich auf ein Verfahren zur Integration eines elektronischen Bauteils in eine Leiterplatte, wobei auf einem wenigstens aus einer leitenden bzw. leitfähigen Schicht und einer nicht-leitenden bzw. isolierenden Schicht gebildeten Laminat der elektronische Bauteil mit zu der isolierenden Schicht gerichteten Kontakten auf dieser festgelegt wird, nach der Festlegung des Bauteils auf der isolierenden Schicht Löcher bzw. Durchbrechungen in der leitenden Schicht und in der isolierenden Schicht entsprechend den Kontakten des Bauteils ausgebildet werden und anschließend eine Kontaktierung der Kontakte mit der leitenden Schicht erfolgt.

Im Zusammenhang mit wachsenden Produktfunktionalitäten von mit elektronischen Bauteilen versehenen Geräten und einer zunehmenden Miniaturisierung derartiger elektronischer Bauteile sowie einer zunehmenden Anzahl elektronischer Bauteile, mit welchen Leiterplatten zu bestücken sind, werden zunehmend leistungsfähige feld- bzw. arrayförmig aufgebaute Bauteile bzw. Packages mit mehreren elektronischen Komponenten eingesetzt, die eine Vielzahl von Kontakten bzw. Anschlüssen bei zunehmend verringertem Abstand dieser Kontakte aufweisen. Zur Festlegung bzw. Kontaktierung derartiger Bauteile wird zunehmend der Einsatz von stark entflochtenen Leiterplatten erforderlich, wobei davon auszugehen ist, dass bei einer gleichzeitigen Verringerung der Produktgröße sowie der einzusetzenden Bauteile und Leiterplatten sowohl hinsichtlich der Dicke als auch der Fläche derartiger Elemente zu erwarten ist, dass eine Bestückung bzw. Anordnung derartiger elektronischer Bauteile über die erforderliche Vielzahl von Kontaktstellen an Leiterplatten problematisch wird bzw. an Grenzen der möglichen Auflösung derartiger Kontaktstellen gelangt.

Zur Lösung derartiger Probleme wurde zwischenzeitlich vorgeschlagen, elektronische Bauteile wenigstens teilweise in eine Leiterplatte zu integrieren, wobei beispielsweise auf die WO 03/065778, die WO 03/065779, die WO 2004/077902, die WO 2006/134216 oder die DE-C 19954941 verwiesen wird. Bei diesen bekannten Verfahren bzw. Ausführungsformen von in einer Leiterplatte integrierten, elektronischen Bauteilen bzw. Komponenten ist jedoch nachteilig, dass für die Aufnahme derartiger elektronischer Bauteile bzw. Komponenten jeweils Ausnehmungen bzw. Löcher in einem insbesondere aus einem leitenden Material gebildeten Element einer Leiterplatte vorzusehen sind, wobei darüber hinaus vor Anordnung eines Bauteils in einem derartigen Loch Leiterbahnen ausgebildet werden. Für eine Kontaktierung der Bauteile werden Lötprozesse und Bondtechniken eingesetzt, wobei üblicherweise Kontaktstellen zwischen Materialien unterschiedlichen Typs zwischen Elementen der Leiterbahnen als auch den Kontakt- bzw. Anschlussstellen der elektronischen Bauteile resultieren. Vor allem bei einem Einsatz derartiger Systeme in Umgebungen mit großem Temperaturunterschied bzw. großen Temperaturwechselbereichen ergeben sich durch den Einsatz unterschiedlicher Materialien im Bereich der Kontakt- bzw. Anschlussstellen unter Berücksichtigung der unterschiedlichen thermischen Ausdehnungskoeffizienten mechanisch bzw. thermisch induzierte Spannungen, welche zum Riss wenigstens einer Kontakt- bzw. Anschlussstelle und somit zum Versagen des Bauteils führen können. Darüber hinaus ist davon auszugehen, dass vor Anordnung des Bauteils zusätzlich erforderliche Bohrungen, insbesondere Laserbohrungen, in leitfähigen Schichten zur Herstellung von Kontaktflächen die Komponenten belasten. Weiters ist nachteilig, dass eine Kontaktierung der in den herzustellenden Ausnehmungen bzw. Vertiefungen eingebetteten Bauteile an Leiterbahnen und Kontaktflächen erschwert wird bzw. insbesondere bei einem Einsatz mit schwankenden Temperaturbelastungen nicht zuverlässig erzielbar ist. Ergänzend ist nachteilig, dass gegebenenfalls vorzusehende, hohe Drücke und Temperaturen während des Leiterplatten-Herstellungsprozesses die eingebetteten und kontaktierten Komponenten belasten.

Darüber hinaus ist es beispielsweise aus der WO 2006/056643 bei einer Herstellung eines elektronischen Moduls bzw. der Einbettung bzw. Integration eines elektronischen Bauteils in eine Leiterplatte bekanntgeworden, auf einem aus einer leitenden bzw. bzw. Leiterschicht und einer nicht-leitenden bzw. Isolatorschicht gebildeten Laminat Öffnungen bzw. Durchbrechungen zumindest in der leitenden Schicht herzustellen, wobei die Position dieser Öffnungen den Positionen von Kontakten eines nachfolgend auf der isolierenden Schicht festzulegenden Bauteils entsprechen soll. Nachteilig bei dieser bekannten Ausführungsform ist insbesondere die Tatsache, dass beispielsweise unter Berücksichtigung der üblicherweise überaus großen Vielzahl von Kontakten derartiger, in eine Leiterplatte zu integrierenden elektronischen Bauteile mit entsprechend geringen Toleranzen die vorab herzustellenden Öffnungen bzw. Durchbrechungen zur nachträglichen Festlegung des Bauteils in einem getrennten bzw. zusätzlichen Verfahrensschritt hergestellt werden müssen. Unter Berücksichtigung der überaus geringen Toleranz aufgrund der geringen Größe derartiger Bauteile ist somit eine exakte Anpassung der vorher herzustellenden Löcher bzw. Durchbrechungen an die Kontakte eines nachträglich festzulegenden Bauteils vorzunehmen, so dass hierdurch nicht nur ein überaus großer, zusätzlicher Aufwand bei der Herstellung derartiger Löcher bzw. Durchbrechungen sondern ein entsprechend hoher Ausschuß bei nicht vollständig exakter Positionierung der Löcher bzw. Durchbrechungen relativ zu den Kontakten eines nachfolgend festzulegenden Bauteils entsteht. Weiters ist bei dieser bekannten Ausführungsform nachteilig, dass in auf die Festlegung des Bauteils an dem mit Löchern bzw. Durchbrechungen versehenen Laminat weitere Verfahrensschritte insbesondere zur Ummantelung des Bauteils und somit zu dessen Einbettung anschließen, wobei während derartiger Verfahrensschritte beispielsweise in den vorab hergestellten Löchern bzw. Durchbrechungen vorhandenes Gas bzw. vorhandene Luft Laminier- bzw. Verpressvorgänge zur Einbettung des Bauteils insbesondere durch eine Blasenbildung nachteilig beeinflusst. Derartige Blasen können darüber hinaus zu zusätzlichen Problemen bei der elektrischen Kontaktierung der Komponenten oder zu einem Ablösen von Komponenten oder Leiterplattenlagen untereinander führen.

In ähnlicher Weise ist beispielsweise der EP-A 1 111 662 ein Verfahren zu entnehmen, wobei vor der Anordnung bzw. Festlegung eines elektronischen Bauteils eine Strukturierung einer leitenden Schicht entsprechend Kontakten des festzulegenden Bauteils vorgenommen wird, wobei über diese vorher vorgenommene Strukturierung bzw. Ausbildung von Löchern bzw. Durchbrechungen zumindest in der leitenden Schicht eines ebenfalls mehrlagigen Laminats wiederum die oben erwähnten Nachteile im Hinblick auf einzuhaltende Toleranzen bzw. die Ausrichtung des nachträglich festzulegenden Bauteils entstehen. Ein zusätzlicher Nachteil einer derartigen vorangehenden Strukturierung einer leitenden Schicht liegt darüber hinaus darin, dass für eine derartige Strukturierung der leitenden Schicht vor der Festlegung des festzulegenden Bauteils eine gegebenenfalls vorhandene Schutzschicht bzw. Trägerschicht vorzeitig entfernt werden muß, wobei dies während nachfolgender Be- bzw. Verarbeitungsschritte zu einer Beeinträchtigung und insbesondere Beschädigung der strukturierten leitenden Schicht, beispielsweise durch Kratzer, ein Aufbringen von Verunreinigungen oder dgl. führt.

Ein Verfahren der eingangs genannten Art ist beispielsweise der FR 2 822 338 A1 zu entnehmen, welches insbesondere darauf abzielt, eine zuverlässige Kontaktierung zwischen Kontakten eines in einer Leiterplatte integrierten elektronischen Bauteils und einer leitenden bzw. strukturierten Schicht bzw. Lage zur Verfügung zu stellen.

Ein weiteres Verfahren ist aus der US 2006/0278967 A1 bekannt.

Darüber hinaus ist aus der Literaturstelle HESSLING M ET AL: "Präzise Löcher Laserbohren von Mikrovias in Leiterplatten", Laser Praxis, Carl Hanser Verlag, München, DE, Nr. 3, 1. Oktober 2001 (2001-10-01), Seiten 14-16, XP001101990, ISSN: 0937-7069, ein Verfahren zum Bohren von Löchern bzw. Durchbrechungen in Leiterplatten bekannt geworden, wobei die Verwendung von unterschiedlichen Lasern zur Herstellung von Löchern bzw. Durchbrechungen in unterschiedlichen Materialien vorgeschlagen wird.

Darüber hinaus ist aus der WO 2005/104636 A1 ein Verfahren zur Herstellung eines elektronischen Moduls bekannt geworden, bei welchem zur Einbettung eines elektronischen Bauteils in eine Leiterplatte die Verwendung von Markierungen vorgeschlagen wird.

Die vorliegende Erfindung zielt somit darauf ab, die oben genannten Probleme gemäß dem Stand der Technik bei einer Integration eines elektronischen Bauteils in einer Leiterplatte zu vermeiden bzw. zu minimieren, wobei insbesondere darauf abgezielt wird, ein Verfahren der eingangs genannten Art zur Verfügung zu stellen, bei welchem bei vereinfachtem und zuverlässigem Verfahrensablauf eine einfache und zuverlässige Positionierung und Einbettung eines elektronischen Bauteils auf bzw. in einem mehrlagigen Laminat einer Leiterplatte erzielbar ist. Insbesondere wird auf eine Vermeidung von zusätzlichen Verfahrensschritten zur Herstellung von Löchern bzw. Durchbrechungen entsprechend den Kontakten des festzulegenden Bauteils vor einer Festlegung desselben und somit eine Verbesserung bzw. Vereinfachung einer Festlegung eines derartigen Bauteils abgezielt.

Zur Lösung dieser Aufgaben wird ein Verfahren nach Anspruch 1 vorgeschlagen. Dabei wird die Ausbildung der Löcher bzw. Durchbrechungen in der leitenden Schicht und in der isolierenden Schicht nach der Festlegung des Bauteils in getrennten Verfahrensschritten vorgenommen und vor der Festlegung des Bauteils an der isolierenden Schicht wenigstens eine Markierung zumindest in der isolierenden Schicht für eine Registrierung bzw. Ausrichtung des Bauteils auf der isolierenden Schicht ausgebildet. Weiterhin wird die wenigstens eine Markierung von einer sowohl die isolierende Schicht als auch die leitende Schicht durchdringenden Bohrung bzw. Durchbrechung gebildet und zusätzlich zur Ausbildung von Löchern bzw. Durchbrechungen in der leitenden Schicht und der nicht-leitenden Schicht entsprechend den Kontakten des Bauteils wenigstens eine zusätzliche Durchbrechung außerhalb des Bereichs der Festlegung des Bauteils an dem Laminat zur Herstellung einer nachfolgenden Durchkontaktierung und/oder zur Herstellung der Kontur eines Leiterplattenelements ausgebildet, wobei die zusätzliche Durchbrechung in Bezug zu der vorab hergestellten Markierung ausgebildet wird.

Da erst nach der Festlegung des Bauteils auf der isolierenden Schicht mit zu der isolierenden bzw. nicht-leitenden Schicht gerichteten Kontakten eine Ausbildung von Löchern bzw. Durchbrechungen entsprechend den Kontakten des bereits festgelegten Bauteils erfolgt, wird ermöglicht, auf aufwendige Positionier- bzw. Ausrichtschritte einer Festlegung des Bauteils im Hinblick auf bereits vorgesehene bzw. vorab hergestellte Öffnungen bzw. Durchbrechungen, wie dies im Stand der Technik der Fall war, zu verzichten, so dass einfach eine zuverlässige Positionierung und Anordnung eines Bauteils an dem Laminat vorgenommen wird. Nach einer derartigen Festlegung des Bauteils an der isolierenden bzw. nicht-leitenden Schicht mit zu dieser gerichteten Kontakten kann in einfacher und zuverlässiger Weise und insbesondere in üblicher Weise bei der Herstellung einer Leiterplatte vorgesehenen weiteren Schritten einer Strukturierung zumindest der leitenden Schicht und entsprechend der bereits an dem Laminat einfach feststellbaren Position des bereits festgelegten Bauteils eine Ausbildung der Löcher bzw. Durchbrechungen sowohl in der leitenden Schicht als auch in der nicht-leitenden Schicht zur Freilegung der Kontakte des Bauteils als auch zur Kontaktierung derselben vorgenommen werden. Es ist somit unmittelbar ersichtlich, dass durch die vorgeschlagene Verfahrensführung einer Ausbildung der Löcher bzw. Durchbrechungen entsprechend den Kontakten des bereits festgelegten Bauteils eine wesentlich einfachere Festlegung und nachfolgend eine zuverlässigere Positionierung und Ausbildung der erforderlichen Löcher bzw. Durchbrechungen zur Kontaktierung der Kontakte unter Verwendung von üblicherweise bei der Herstellung von Leiterplatten bekannten Verfahrensschritten erzielbar ist. Es kann insbesondere der Aufwand für eine exakte Positionierung des festzulegenden Bauteils auf dem Laminat unter Berücksichtigung der Tatsache, dass die Löcher bzw. Durchbrechungen zur Kontaktierung der Kontakte erst nachfolgend auf die Festlegung des Bauteils auf dem Laminat erzeugt werden, entsprechend gegenüber dem oben genannten Stand der Technik vereinfacht werden und somit der Zeitaufwand bei der Herstellung der Leiterplatte unter Integration wenigstens eines Bauteils minimiert bzw. reduziert werden. Unter Berücksichtigung der für die Ausbildung der isolierenden bzw. nicht-leitenden Schicht als auch der leitenden bzw. leitfähigen Schicht eingesetzten Materialien und darüber hinaus unter Berücksichtigung von gegebenenfalls bekannten bzw. allgemein eingesetzten Verfahrensschritten im Zusammenhang mit der Herstellung und Bearbeitung einer mehrlagigen Leiterplatte wird erfindungsgemäß vorgeschlagen, dass die Ausbildung der Löcher bzw. Durchbrechungen in der leitenden Schicht und in der isolierenden Schicht nach der Festlegung des Bauteils in getrennten Verfahrensschritten vorgenommen wird. Derart gelingt es, insbesondere in Abstimmung mit jeweiligen Materialeigenschaften der leitenden bzw. leitfähigen Schicht als auch der nicht-leitenden Schicht optimierte Verfahren zur Herstellung der Löcher bzw. Durchbrechungen einzusetzen. Hiebei kann die Ausbildung der Löcher bzw. Durchbrechungen auch im Zusammenhang mit der Durchführung weiterer Verfahrensschritte unabhängig von dem Bereich der Festlegung des Bauteils, beispielsweise einer Strukturierung einzelner Schichten bzw. Lagen der Leiterplatte vorgenommen werden. Zur Unterstützung der Positionierung bzw. Ausrichtung des Bauteils auf dem Laminat wird erfindungsgemäß darüber hinaus vorgeschlagen, dass vor der Festlegung des Bauteils an der isolierenden Schicht wenigstens eine Markierung zumindest in der isolierenden Schicht für eine Registrierung bzw. Ausrichtung des Bauteils auf der isolierenden Schicht ausgebildet wird. Eine derartige Markierung kann gegebenenfalls lediglich auch als Vertiefung ausgebildet sein, wodurch sich Vorteile bei der weiteren Bearbeitung bzw. Verarbeitung erzielen lassen. Darüber hinaus ist davon auszugehen, dass eine derartige Markierung nicht nur für die Festlegung des Bauteils sondern auch für weitere Bearbeitungsschritte herangezogen werden kann.

Insbesondere für eine Verwendung einer derartigen Markierung beispielsweise auch im Zusammenhang mit nachfolgenden Bearbeitungsschritten ist erfindungsgemäß vorgesehen, dass die wenigstens eine Markierung von einer sowohl die isolierende Schicht als auch die leitende Schicht durchdringenden Bohrung bzw. Durchbrechung gebildet wird.

Neben einer einfachen und zuverlässigen Herstellung von Löchern bzw. Durchbrechungen entsprechend den Kontakten des bereits festgelegten Bauteils ist erfindungsgemäß darüber hinaus vorgesehen, dass zusätzlich zur Ausbildung von Löchern bzw. Durchbrechungen in der leitenden Schicht und nicht-leitenden Schicht entsprechend den Kontakten des Bauteils wenigstens eine weitere Durchbrechung außerhalb des Bereichs der Festlegung des Bauteils an dem Laminat zur Ausbildung einer zusätzlichen Durchbrechung zur Herstellung einer nachfolgenden Durchkontaktierung und/oder zur Herstellung der Kontur eines Leiterplattenelements ausgebildet wird. Durch eine derartige Herstellung wenigstens einer weiteren Durchbrechung außerhalb des Bereichs der Festlegung des Bauteils und somit der Kontakte desselben insbesondere für die Herstellung einer nachfolgenden Durchkontaktierung wird es möglich, dass eine derartige Durchbrechung bzw. Bohrung viel näher an dem festgelegten Bauteil angebracht bzw. ausgeführt werden kann. Eine derartige zusätzliche Durchbrechung muss somit nicht in einem nachfolgenden bzw. unabhängigen Verfahrensschritt, beispielsweise als eine mechanische Bohrung am Ende des gesamten Herstellungsprozesses der Leiterplatte ausgeführt werden, wobei bei einer nachträglichen bzw. unabhängigen Herstellung einer derartigen zusätzlichen Bohrung bedeutend größere Prozeßtoleranzen insbesondere zur Vermeidung einer Beschädigung des bereits festgelegten Bauteils einzuhalten sind bzw. wären. Bei Heranziehung der wenigstens einen zusätzlichen bzw. weiteren Durchbrechung zur Herstellung der Kontur eines Leiterplattenelements bzw. der Leiterplatte entsprechend dem Umriß einer fertigen bzw. herzustellenden Leiterplatte wird es darüber hinaus möglich, ähnlich wie bei der Herstellung einer nachträglichen Durchkontaktierung auf nachfolgende mechanische Trennverfahren, wie beispielsweise ein Fräsen zur Herstellung der Kontur der Leiterplatte zu verzichten. Es kann somit in einem gemeinsamen Verfahrens- bzw. Prozeßschritt auch gleichzeitig die Kontur der herzustellenden Leiterplatte unter Miniaturisierung derselben, entsprechend den Rändern der Leiterplatte, durch geringere Prozeßtoleranzen näher an dem festzulegenden Bauteil ausgeführt werden. Insgesamt ermöglicht der Einsatz beispielsweise eines Laserbohrvorgangs bzw. von Lasertechnologie zur Herstellung der weiteren Durchbrechung zur Herstellung einer Durchkontaktierung und/oder zur Herstellung der Kontur der Leiterplatte eine präzisiere Ausführung derartiger zusätzlicher Durchbrechungen im Gegensatz zu mechanischen Bearbeitungsvorgängen. Weiters wird die Registrierung bzw. Ausrichtung insbesondere dadurch verbessert, dass sämtliche Löcher bzw. Durchbrechungen sowohl zur Kontaktierung des Bauteils durch Freilegen der Kontakte als auch zur Herstellung zusätzlicher Durchbrechungen in einem gemeinsamen Arbeitsschritt mit einer gemeinsamen Ausrichtung bzw. Registrierung durchgeführt werden. Durch eine Ausbildung wenigstens einer weiteren Durchbrechung während bzw. gemeinsam mit der Ausbildung von Löchern bzw. Durchbrechungen in der leitenden Schicht und in weiterer Folge auch der isolierenden Schicht wird es somit möglich, eine üblicherweise angestrebte Miniaturisierung der herzustellenden Leiterplatte durch eine Verringerung von gegenseitigen Abständen einzelner Elemente bzw. einer derartigen Durchkontaktierung oder der Kontur der herzustellenden Leiterplatte von einem integrierten Bauteil zu unterstützen. Es lässt sich somit eine bedeutend bessere Ausnutzung der zur Verfügung stehenden Fläche erzielen.

Zur weiteren Vereinfachung des Herstellungsvorgangs bzw. zur Erhöhung der Genauigkeit insbesondere der Anordnung der zusätzlichen bzw. weiteren Durchbrechung ist erfindungsgemäß zusätzlich vorgesehen, dass die zusätzliche Durchbrechung in Bezug zu der vorab hergestellten Markierung ausgebildet wird. Durch Anordnung der zusätzlichen Durchbrechung, welche beispielsweise zur Herstellung einer Durchkontaktierung oder zur Bereitstellung der Kontur der Leiterplatte eine insbesondere gegenüber den Abmessungen der Löcher bzw. Durchbrechungen entsprechend den Kontakten größere Abmessung aufweist, im Bereich der vorab hergestellten Markierung wird nicht nur eine exakte Positionierung der zusätzlichen bzw. weiteren Durchbrechung erzielt, sondern es kann auch der Aufwand für die Positionierung zur Herstellung dieser zusätzlichen Durchbrechung entsprechend minimiert werden.

Wie bereits oben erwähnt, erfolgt nach einer Festlegung eines derartigen Bauteils zur Einbettung desselben üblicherweise eine Ummantelung, wobei in diesem Zusammenhang gemäß einer bevorzugten Ausführungsform des erfindungsgemäßen Verfahrens vorgeschlagen wird, dass der elektronische Bauteil nach dem Festlegen an der isolierenden Schicht in an sich bekannter Weise von einem isolierenden Material, insbesondere wenigstens einer Prepreg-Folie und/oder einem Harz umgeben bzw. ummantelt wird. Für eine derartige Einbettung bzw. Ummantelung können entsprechend der Form des bereits festgelegten Bauteils vorgefertigte Prepreg-Folien verwendet werden oder es kann eine Mehrzahl von Schichten aus einem isolierenden Material bzw. Harzmaterial eingesetzt werden.

Für eine zuverlässige und sichere Einbettung des elektronischen Bauteils wird darüber hinaus bevorzugt vorgeschlagen, dass die Ummantelung des elektronischen Bauteils durch einen Preß- bzw. Laminiervorgang einer Mehrzahl von isolierenden Schichten vorgenommen wird. Insbesondere unter Berücksichtigung der Tatsache, dass Löcher bzw. Durchbrechungen zur Kontaktierung der Kontakte des Bauteils nach der Festlegung desselben und insbesondere auch nach einer Ummantelung des elektronischen Bauteils beispielsweise durch einen Press- bzw. Laminiervorgang ausgebildet werden, wird sichergestellt, dass ein derartiger Press- bzw. Laminiervorgang zur Einbettung des Bauteils unter Einsatz von jeweils im wesentlichen vollflächigen Schichten bzw. Lagen erfolgt. Derart existieren insbesondere im Gegensatz zum bekannten Stand der Technik keinerlei Einschlüsse von Luft bzw. Gas in wenigstens einzelnen Schichten, welche zu einer nicht ordnungsgemäßen Verbindung einzelner Schichten während eines derartigen Preß- bzw. Laminiervorgangs führen können, wie dies bei dem eingangs genannten Stand der Technik auftritt, bei welchem vor der Festlegung des Bauteils bereits Löcher bzw. Durchbrechungen entsprechend den Kontakten des nachfolgend festzulegenden Bauteils vorgesehen sind.

Für eine besonders zuverlässige und sichere Festlegung des Bauteils auf dem Laminat bzw. insbesondere der isolierenden Schicht wird gemäß einer weiters bevorzugten Ausführungsform vorgeschlagen, dass der elektronische Bauteil auf der isolierenden Schicht in an sich bekannter Weise mittels eines Klebers festgelegt wird.

Zur Erzielung einer zuverlässigen Wärmeabfuhr, welche bei einer entsprechend hohen Integrationsdichte als auch Kompaktdichtheit des aufzunehmenden Bauteils gegebenenfalls erforderlich ist, wird darüber hinaus vorgeschlagen, dass ein thermisch leitendes bzw. leitfähiges Klebematerial, beispielsweise Kleber oder Klebestreifen verwendet wird, wie dies einer weiters bevorzugten Ausführungsform des erfindungsgemäßen Verfahrens entspricht.

Im Zusammenhang mit der Ausbildung der Löcher bzw. Durchbrechungen in dem Laminat wird gemäß einer weiters bevorzugten Ausführungsform vorgeschlagen, dass die Löcher bzw. Durchbrechungen in der leitenden Schicht durch einen Bohrvorgang, insbesondere ein Laserbohren, oder einen Ätzvorgang ausgebildet werden. Derartige Bohrvorgänge, beispielsweise bzw. insbesondere ein Laserbohren, sind im Zusammenhang mit der Herstellung einer Leiterplatte für sich gesehen bekannt, so dass die nach der Festlegung des elektronischen Bauteils an dem Laminat erforderliche Ausbildung der Löcher bzw. Durchbrechungen, wie oben bereits erwähnt, im Rahmen von weiteren Strukturierungsvorgängen, insbesondere der leitenden Schicht vorgenommen werden kann, so dass insbesondere auf eine Berücksichtigung zusätzlicher Verfahrensschritte verzichtet werden kann, welche einen zusätzlichen Zeitaufwand bei der Herstellung bzw. Bearbeitung einer derartigen Leiterplatte erfordern würden. Darüber hinaus wird erfindungsgemäß alternativ vorgeschlagen, die Löcher bzw. Durchbrechungen in der leitenden Schicht durch einen Ätzvorgang im Rahmen eines Photostrukturierungsprozesses auszubilden. Ein derartiger Ätzvorgang im Rahmen eines Photostrukturierungsprozesses ist ebenfalls im Zusammenhang mit der Herstellung einer Leiterplatte für sich gesehen bekannt und kann zumindest in speziellen Anwendungen zu einer weiteren Beschleunigung des Herstellungsvorgangs durch eine Zeiteinsparung bei Durchführung eines derartigen Ätzvorgangs gegenüber einer Ausbildung einzelner Löcher bzw. Durchbrechungen mittels eines Lasers führen.

Zur Herstellung der Löcher bzw. Durchbrechungen entsprechend den Kontakten des bereits festgelegten und günstigerweise ummantelten bzw. eingebetteten Bauteils mit erforderlicher Präzision sowie unter möglichst geringem Zeitaufwand wird gemäß einer weiters bevorzugten Ausbildungsform des erfindungsgemäßen Verfahrens vorgeschlagen, dass bei getrennter Ausbildung der Löcher bzw. Durchbrechungen in der leitenden Schicht ein UV-Laser verwendet wird. Mit derartigen leistungsstarken UV-Lasern kann in einfacher und zuverlässiger Weise und mit entsprechender Genauigkeit und unter kurzem Zeitaufwand eine Ausbildung einer gegebenenfalls großen Anzahl von Löchern bzw. Durchbrechungen entsprechend den Kontakten des bereits festgelegten Bauteils vorgenommen werden.

Um einen übermäßigen Aufwand bei der Einstellung bzw. Durchführung des Bohrvorgangs durch ein Laserbohren mittels eines UV-Lasers in der leitenden bzw. leitfähigen Schicht zu vermeiden, da bei einer gleichzeitigen Entfernung der isolierenden Schicht enge Toleranzen insbesondere zur Vermeidung einer Beschädigung des daran anschließenden Kontakts des bereits festgelegten Bauteils einzuhalten wären, wird gemäß einer weiters bevorzugten Ausführungsform vorgeschlagen, dass die Löcher bzw. Durchbrechungen in der isolierenden Schicht durch einen Laser, insbesondere einen CO₂-Laser ausgebildet werden. Durch einen Einsatz eines weiteren Lasers, insbesondere eines CO₂-Lasers zur Herstellung der Löcher bzw. Durchbrechungen in der isolierenden Schicht in einem weiteren bzw. getrennten Verfahrensschritt, wie dies oben bereits angedeutet wurde, können nicht nur einfachere und kostengünstigere CO₂-Laser verwendet werden, welche gegenüber einem UV-Laser eine höhere Geschwindigkeit bzw. Rate einer Herstellung der Löcher entsprechend den Kontakten des bereits festgelegten Bauteils ermöglichen, sondern es wird auch eine Beschädigung der nach Entfernung der isolierenden Schicht und gegebenenfalls Rückständen eines Klebers freizulegenden Kontakte des bereits festgelegten, elektronischen Bauteils mit Sicherheit vermieden. Es lässt sich somit durch Einsatz derartiger weiterer Laser, deren Einsatz im Zusammenhang mit der Herstellung von Leiterplatten ebenfalls für sich gesehen bekannt ist, eine entsprechend rasche und sichere Entfernung des isolierenden Materials nach der bereits vorgenommenen Ausbildung von Löchern bzw. Durchbrechungen in der leitenden Schicht vornehmen.

Zur Erleichterung der Ausrichtung des Laserstrahls zur Entfernung des Materials der isolierenden Schicht im Bereich der Löcher bzw. Durchbrechungen der leitenden bzw. leitfähigen Schicht entsprechend der Position der Kontakte des bereits festgelegten Bauteils wird gemäß einer weiters bevorzugten Ausführungsform vorgeschlagen, dass bei getrennter Ausbildung der Löcher bzw. Durchbrechungen in der isolierenden Schicht ein Laserstrahl eingesetzt wird, dessen Abmessung bzw. Durchmesser die lichte Weite der Löcher bzw. Durchbrechungen in der leitenden Schicht übersteigt. Dadurch, dass die Abmessung bzw. der Durchmesser des zur Herstellung der Löcher bzw. Durchbrechungen in der isolierenden Schicht eingesetzten Laserstrahls die lichte Weite der Löcher bzw. Durchbrechungen in der leitenden Schicht übersteigt, kann mit einer geringeren Präzision im Hinblick auf die Ausrichtung des Laserstrahls jeder herzustellenden Durchbrechung das Auslangen gefunden werden, da durch die entsprechende Auswahl der Abmessungen bzw. des Durchmessers des Laserstrahls das jeweilige Loch bzw. die Durchbrechung in der isolierenden Schicht entsprechend rasch und zuverlässig hergestellt wird, während durch die leitende bzw. leitfähige Schicht sichergestellt wird, dass nicht auch umgebendes Material der isolierenden bzw. nicht-leitenden Schicht durch den Laserstrahl beeinträchtigt wird. Insgesamt lässt sich somit mit geringeren Anforderungen im Hinblick auf die Präzision einer Ausrichtung bzw. Orientierung des Lasers das Auslangen finden, wodurch die Verfahrensgeschwindigkeit zur Herstellung der Löcher bzw. Durchbrechungen in der isolierenden Schicht weiter erhöht werden kann.

Unter Berücksichtigung der üblicherweise für isolierende Schichten eingesetzten Materialien und zur Erzielung entsprechend hoher Prozessgeschwindigkeiten bei zuverlässigem Entfernen des isolierenden Materials entsprechend den bereits vorab hergestellten Löchern bzw. Durchbrechungen in der leitenden Schicht und entsprechend den Kontakten des bereits festgelegten Bauteils kann vorgesehen sein, dass zur getrennten Ausbildung der Löcher bzw. Durchbrechungen in der isolierenden Schicht ein Laser, insbesondere gepulster CO₂-Laser, mit einer Leistung von 0,1 bis 75 W, insbesondere von 0,1 bis 7 W, für einen Zeitraum bzw. eine Pulslänge von 0,1 bis 20 µs eingesetzt wird.

Während oben die Vorteile einer getrennten Ausbildung der Löcher bzw. Durchbrechungen sowohl in der leitenden bzw. leitfähigen Schicht als auch in der isolierenden Schicht in Übereinstimmung mit der Position der Vielzahl der Kontakte des auf der isolierenden Schicht festgelegten Bauteils erörtert wurden, kann zur Verringerung der Verfahrensschritte vorgesehen sein, dass die Löcher bzw. Durchbrechungen in der leitenden Schicht und in der isolierenden Schicht in einem gemeinsamen Verfahrensschritt unter Einsatz eines CO₂-Lasers nach einer Vorbehandlung der leitenden Schicht ausgebildet werden. Derart kann durch Verwendung eines einzigen Lasers, insbesondere eines CO₂-Lasers, eine Herstellung von Löchern bzw. Durchbrechungen sowohl in der leitenden bzw. leitfähigen Schicht als auch in der isolierenden Schicht vorgenommen werden, so dass auf den Einsatz beispielsweise unterschiedlicher Laser oder allgemein unterschiedlicher Verfahrensschritte zur Herstellung der Löcher bzw. Durchbrechungen sowohl in der isolierenden Schicht als auch in der leitenden Schicht verzichtet werden kann. Da ein CO₂-Laser üblicherweise nicht unmittelbar zur Herstellung von Löchern bzw. Durchbrechungen in einem leitenden bzw. leitfähigen Material einsetzbar ist, wird vorgeschlagen, dass eine entsprechende Vorbehandlung der leitenden Schicht vorgesehen ist, welche auch mit insbesondere vertretbarem Zeitaufwand eine Bearbeitung einer leitenden bzw. leitfähigen Schicht ermöglicht. Eine derartige Vorbehandlung soll hiebei insbesondere die Herstellung von Löchern bzw. Durchbrechungen in der leitenden bzw. leitfähigen Schicht bei Einsatz eines CO₂-Lasers unterstützen.

In diesem Zusammenhang kann vorgesehen sein, dass als Vorbehandlung der leitenden Schicht eine Kupferoxidschicht auf der leitenden Schicht ausgebildet wird, welche insbesondere durch eine zusätzliche organische oder metallorganische Schicht abgedeckt wird. Eine Ausbildung einer derartigen Kupferoxidschicht und gegebenenfalls bzw. insbesondere einer zusätzlichen organischen oder metallorganischen Schicht ermöglicht bei Einsatz eines CO₂-Lasers unmittelbar eine Herstellung von Löchern bzw. Durchbrechungen in der leitenden bzw. leitfähigen Schicht. Durch Einsatz eines einzigen Bohrvorgangs, insbesondere Laserbohrvorgangs, durch Einsatz eines CO₂-Lasers zur Herstellung von Durchbrechungen bzw. Löchern sowohl in der leitenden als auch nicht-leitenden bzw. isolierenden Schicht kann somit auf die Bereitstellung voneinander getrennter Verfahrensschritte zur Herstellung der Löcher bzw. Durchbrechungen in den einzelnen Schichten verzichtet werden.

Zur Herstellung der Löcher bzw. Durchbrechungen sowohl in der leitenden Schicht als auch in der isolierenden Schicht entsprechend den Kontakten des bereits an der isolierenden Schicht festgelegten Bauteils, welche durch die Herstellung der Löcher bzw. Durchbrechungen freizulegen sind, wird darüber hinaus vorgeschlagen, dass zur Entfernung der leitenden Schicht als auch isolierenden Schicht in einem gemeinsamen Verfahrensschritt eine Pulsdauer des CO₂-Lasers von wenigstens 200 µs, insbesondere wenigstens 250 µs und eine Pulsanzahl von maximal 5, insbesondere maximal 3 Pulsen gewählt werden. Durch eine derartige Wahl der Parameter des einzusetzenden CO₂-Lasers gelingt nach der Vorbehandlung der leitenden bzw. leitfähigen Schicht sowohl eine zuverlässige und präzise Herstellung der Löcher bzw. Durchbrechungen in der leitenden bzw. leitfähigen Schicht als auch in einem gemeinsamen Bohrvorgang der Löcher in der nicht-leitenden bzw. isolierenden Schicht, so dass in einem gemeinsamen Arbeitsschritt unmittelbar die Kontakte des bereits an der isolierenden Schicht festgelegten Bauteils freigelegt werden.

Zur Vermeidung von Beeinträchtigungen insbesondere einer weiteren Strukturierung der leitenden bzw. leitfähigen Schicht nach Ausbildung der Löcher bzw. Durchbrechungen in einem gemeinsamen Schritt als auch für eine ordnungsgemäß nachfolgend vorzunehmende Kontaktierung der freigelegten Kontakte des festgelegten Bauteils wird vorgeschlagen, dass die als Vorbehandlung der leitenden Schicht aufgebrachte zusätzliche Schicht nach Ausbildung der Löcher bzw. Durchbrechungen und vor weiteren Bearbeitungsschritten insbesondere durch einen Ätzschritt entfernt wird. Ein derartiger Ätzschritt ist im Zusammenhang mit der Herstellung einer Leiterplatte für sich gesehen bekannt und kann gegebenenfalls mit einem in anderem Zusammenhang vorgesehenen Reinigungs- oder Ätzschritt kombiniert werden, so dass auf einen zusätzlichen Verfahrensschritt verzichtet werden kann.

Zur weiteren Vereinfachung der Verfahrensführung und insbesondere zur Vermeidung zusätzlicher Verfahrensschritte wird gemäß einer weiters bevorzugten Ausführungsform vorgeschlagen, dass zur Ausbildung der Durchbrechung für die Durchkontaktierung und/oder Kontur der bzw. die für die Ausbildung der Durchbrechungen bzw. Löcher in der leitenden und isolierenden Schicht vorgesehene(n) Laserstrahl(en) verwendet wird bzw. werden. Wie oben bereits erwähnt, kann insbesondere durch Einsatz gegebenenfalls unterschiedlicher Laser die Bearbeitung bzw. Strukturierung der leitenden bzw. leitfähigen Schicht als auch die nachträgliche Entfernung des Materials der isolierenden Schicht zur Herstellung der zusätzlichen Durchbrechung somit entsprechend rasch und zuverlässig und in einem gemeinsamen Arbeitsschritt mit der Herstellung der Löcher bzw. Durchbrechungen entsprechend den Kontakten des festgelegten Bauteils beispielsweise für eine nachfolgende Durchkontaktierung hergestellt bzw. zur Verfügung gestellt werden.

Insbesondere zum Schutz bzw. zur Vereinfachung der Handhabung sowohl des Laminats als auch des daran festzulegenden Bauteils wird gemäß einer weiters bevorzugten Ausführungsform des erfindungsgemäßen Verfahrens vorgeschlagen, dass wenigstens eine Träger- bzw. Schutzschicht an der leitenden Schicht an der von der isolierenden Schicht abgewandten Oberfläche vor der Festlegung des Bauteils vorgesehen wird, welche vor der Ausbildung der Löcher bzw. Durchbrechungen in der leitenden Schicht insbesondere nach einer Ummantelung des Bauteils wiederum entfernt wird. Eine derartige Träger- bzw. Schutzschicht kann insbesondere gemeinsam mit dem aus wenigstens einer leitenden und einer nicht-leitenden bzw. isolierenden Schicht bereitgestellten Laminat zur Verfügung gestellt werden, so dass während des Vorgangs einer Festlegung des Bauteils als auch insbesondere einer nachfolgenden Ummantelung desselben vor einer Ausbildung der Löcher bzw. Durchbrechungen insbesondere die gegebenenfalls eine äußerst geringe Dicke aufweisende leitende Schicht vor Beschädigungen geschützt werden kann.

Zur Erzielung einer entsprechenden guten Schutzwirkung wird in diesem Zusammenhang gemäß einer weiters bevorzugten Ausführungsform vorgeschlagen, dass eine Träger- bzw. Schutzschicht von einem metallischen Blech oder Polymer gebildet wird. Ein derartiges metallisches Blech, wie beispielsweise ein Stahl- oder Aluminiumblech, kann auch als Preßblech Verwendung finden und kann beispielsweise während eines oben beschriebenen Laminier- bzw. Preßvorgangs zur Einbettung bzw. Ummantelung des an der isolierenden Schicht festgelegten Bauteils insbesondere die leitende Schicht bei den während des Preß- bzw. Laminiervorgangs auftretenden hohen Belastungen schützen. Anstelle eines metallischen Blechs können für die Schutz- bzw. Trägerschicht auch nicht-leitende Materialien, wie beispielsweise Polymere eingesetzt werden, welche zumindest während Verfahrensschritten vor der Herstellung der Löcher bzw. Durchbrechungen ebenfalls einen entsprechenden Schutz insbesondere der leitenden Schicht vor einer Beschädigung oder Verunreinigung zur Verfügung stellen.

Zur Erzielung einer entsprechend guten Verbundwirkung insbesondere bei der Einbettung bzw. Ummantelung des in die Leiterplatte zu integrierenden Bauteils wird gemäß einer weiters bevorzugten Ausführungsform vorgeschlagen, dass die zum Bauteil gewandte isolierende Schicht von einer die Haftung zwischen der leitenden Schicht und dem den Bauteil umgebenden Material verbessernden Schicht, beispielsweise einer metallorganischen Schicht oder einer Harzschicht oder dgl. gebildet wird.

Durch die erfindungsgemäß vorgeschlagene Verfahrensführung einer Ausbildung der Löcher bzw. Durchbrechungen entsprechend den Kontakten des festzulegenden bzw. zu integrierenden Bauteils nach der Festlegung desselben an der isolierenden Schicht können zur Herstellung der Kontaktierung der Kontakte des eingebetteten bzw. festgelegten elektronischen Bauteils nach der Herstellung der Löcher bzw. Durchbrechungen unterschiedliche Verfahren zur Kontaktierung mit der leitenden Schicht des Laminats und gegebenenfalls zusätzlichen leitenden Schichten zur Verfügung gestellt werden. Hiebei wird insbesondere zur Herstellung von Geometrien von leitenden Verbindungen mit geringen Abmessungen, beispielsweise Abmessungen und Abständen geringer als 50 µm gemäß einer weiters bevorzugten Ausführungsform vorgeschlagen, dass die leitende Schicht zur Kontaktierung der Kontakte des Bauteils und/oder die leitende Schicht des Laminats zur Ausbildung einer leitenden Struktur durch ein semiadditives oder subtraktives Verfahren aufgebracht und/oder strukturiert wird.

Das erfindungsgemäße Verfahren wird nachfolgend anhand von in der beiliegenden Zeichnung schematisch dargestellten Ausführungsformbeispielen näher erläutert. In dieser zeigen:

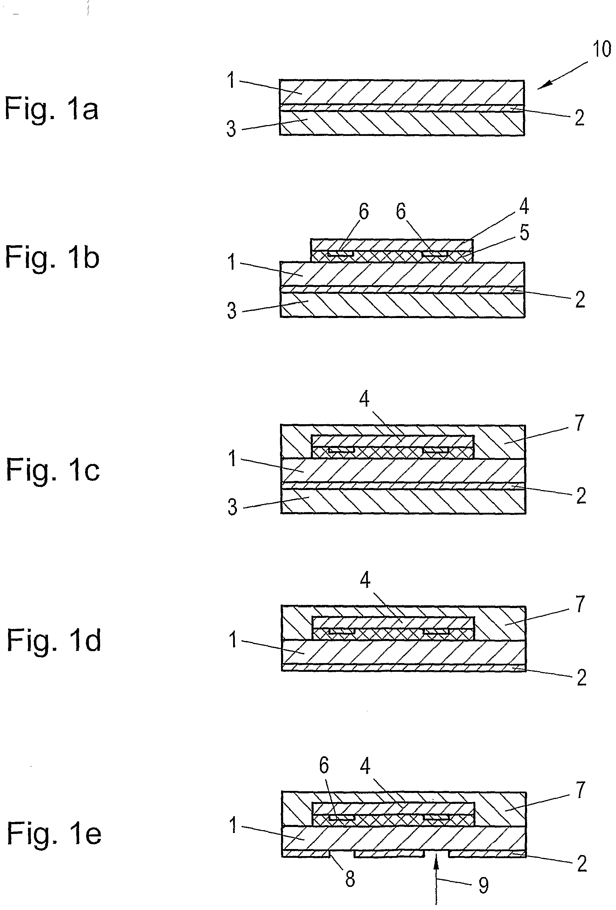

Fig. 1a bis 1j unterschiedliche Schritte eines Verfahrens zur Integration eines elektronischen Bauteils in eine Leiterplatte sowie zur nachfolgenden Strukturierung im Rahmen eines subtraktiven Verfahrens, wobei das dargestellte Verfahren jedoch nicht Teil der Erfindung ist.

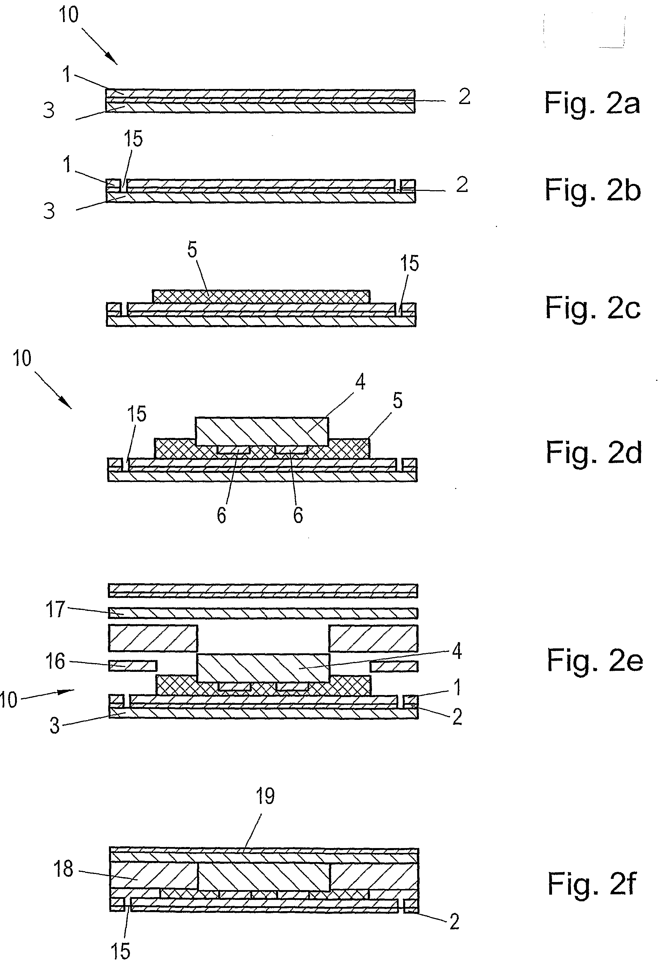

Fig. 2a bis 2j unterschiedliche Schritte einer Ausführungsform des erfindungsgemäßen Verfahrens zur Integration eines elektronischen Bauteils in einer Leiterplatte, wobei zusätzlich die Anordnung wenigstens einer weiteren Durchbrechung zur Herstellung einer Durchkontaktierung und/oder einer Kontur der Leiterplatte angedeutet ist;

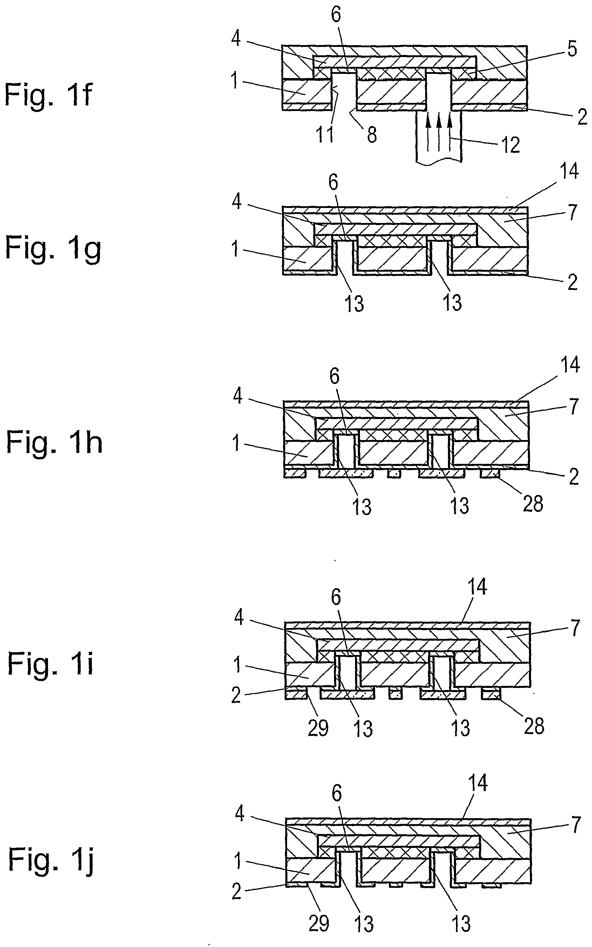

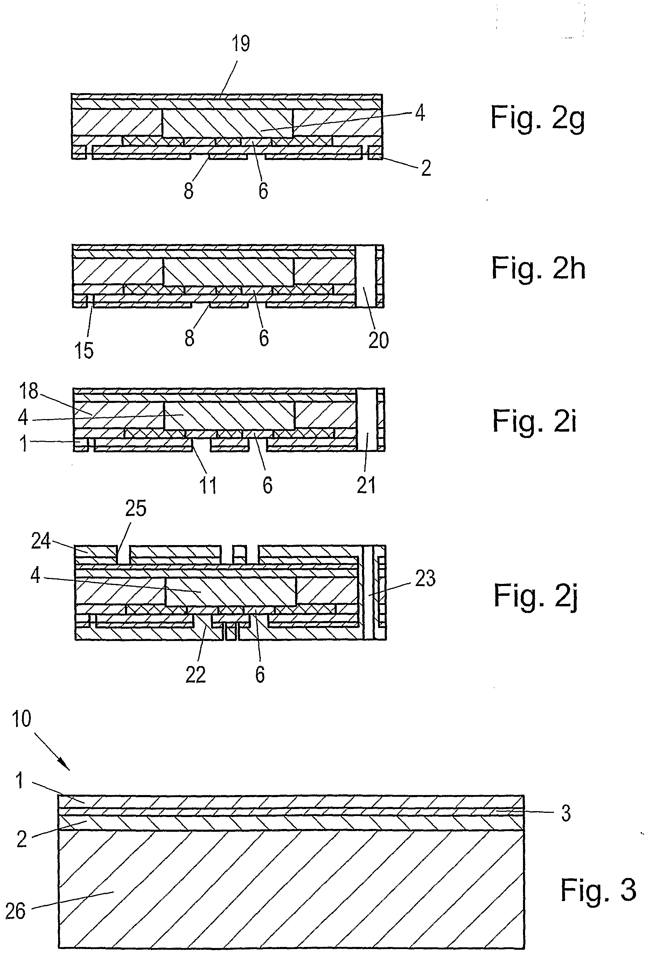

Fig. 3 in vergrößertem Maßstab einen Schnitt durch eine weitere abgewandelte Ausführungsform eines Laminats, an welchem ein Bauteil beispielsweise entsprechend dem in Fig. 1 dargestellten Verfahren und der in Fig. 2 gezeigten erfinderischen Ausführungsform festzulegen ist;

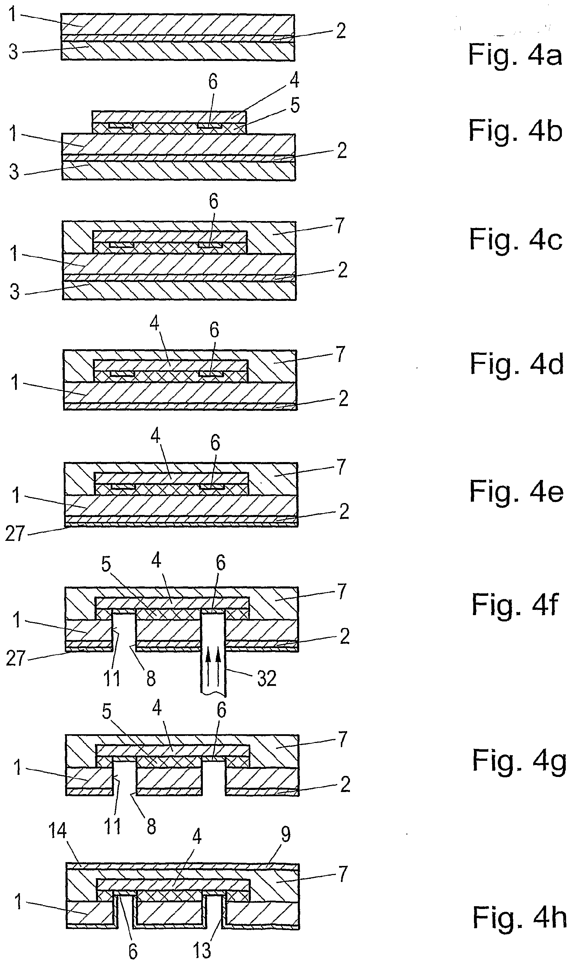

Fig. 4a bis 4h ähnlich der Darstellung gemäß Fig. 1 unterschiedliche Schritte einer weiteren abgewandelten Ausführungsform eines Verfahrens zur Integration eines elektronischen Bauteils in eine Leiterplatte, wobei die Löcher in der leitenden und der isolierenden Schicht in einem gemeinsamen Arbeitsschritt hergestellt werden. Die dargestellte Ausführungsform ist jedoch nicht Teil der Erfindung.

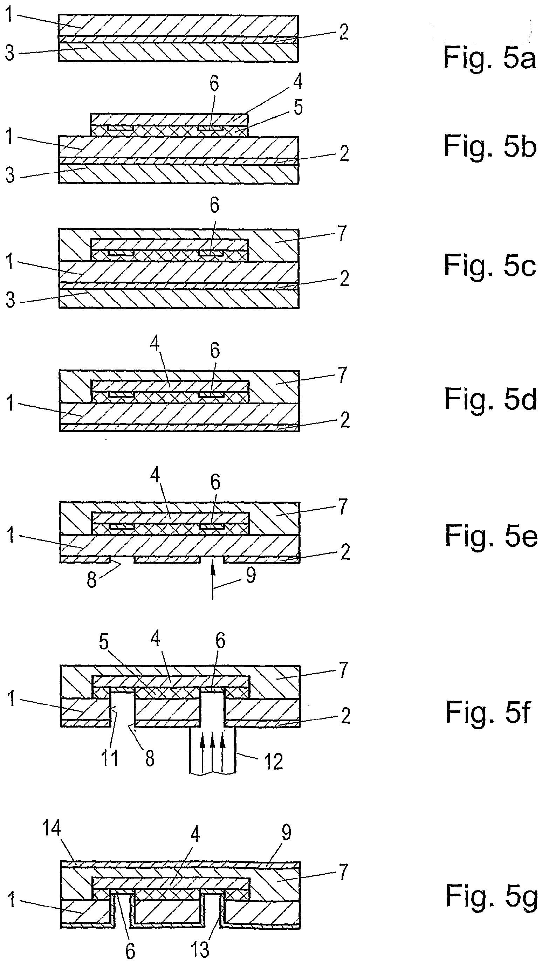

Fig. 5a bis 5k unterschiedliche Schritte eines weiteren abgewandelten Verfahrens zur Integration eines elektronischen Bauteils in einer Leiterplatte, wobei im Gegensatz zu der Verfahrensführung gemäß Fig. 1 eine nachfolgende Strukturierung im Rahmen eines semiadditiven Verfahrens vorgenommen wird. Die dargestellte Ausführungsform ist jedoch nicht Teil der Erfindung.

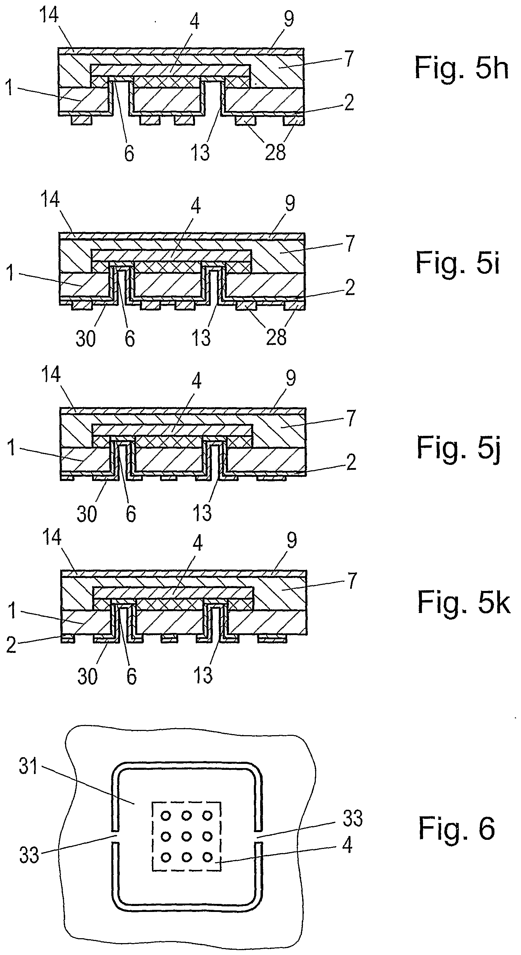

Fig. 6 eine schematische Draufsicht auf eine gemäß dem erfindungsgemäßen Verfahren hergestellte Leiterplatte, wobei eine zusätzliche Durchbrechung außerhalb des Bereichs des festgelegten bzw. integrierten elektronischen Bauteils zur Herstellung der Kontur des Leiterplattenelements herangezogen wird.

In sämtlichen Figuren ist lediglich ein Teilbereich einer herzustellenden Leiterplatte im Bereich einer Festlegung eines in die Leiterplatte zu integrierenden, elektronischen Bauteils schematisch dargestellt. Hierbei ist davon auszugehen, daß insbesondere dargestellte Dicken einzelner Schichten bzw. Lagen als auch Abmessungen des elektronischen Bauteils sowie Abstände einer lediglich beispielhaft dargestellten, geringen Anzahl von Kontakten bzw. Kontaktstellen sowie Abmessungen von Löchern bzw. Durchbrechungen zur Kontaktierung der Kontaktstellen nicht maßstabgetreu sind.

In einem ersten Verfahrensschritt gemäß Fig. 1a wird ein Laminat 10 zur Abstützung eines. nachfolgend dargestellten, in eine herzustellende Leiterplatte zu integrierenden elektronischen Bauteils zur Verfügung gestellt, wobei eine isolierende bzw. nicht-leitende Schicht 1, eine leitende bzw. leitfähige Schicht 2 und bei der in Fig. 1a dargestellten Ausführungsform zusätzlich eine Schutz- bzw. Trägerschicht 3 vorgesehen sind. Die dargestellte Ausführungsform ist jedoch nicht Teil der Erfindung.

Die Schutz- bzw. Trägerschicht 3 dient hiebei insbesondere zum Schutz der gegebenenfalls eine vergleichsweise geringe Dicke von beispielsweise 50 µm oder weniger aufweisenden leitenden Schicht 2, welche beispielsweise von einer Kupferschicht gebildet ist.

Die leitende Schicht 2 kann hiebei von einer gewalzten Kupferschicht gebildet sein, wobei ein Laminat, bestehend zumindest aus der isolierenden bzw. nicht-leitenden Schicht 1 und der leitenden Schicht 2, in einfacher Weise und kostengünstig zur Verfügung gestellt werden kann.

Auf das von der Schicht 1, 2 und 3 gebildete Laminat 10 wird in dem in Fig. 1b dargestellten Verfahrensschritt ein elektronischer Bauteil 4 unter Verwendung eines Klebers 5 an der isolierenden Schicht 1 festgelegt, wobei Kontakte 6 des elektronischen Bauteils 4 zu der isolierenden Schicht 1 gerichtet sind.

Nach der Festlegung des elektronischen Bauteils 4 an der isolierenden Schicht erfolgt eine Einbettung bzw. Ummantelung desselben durch Anordnung eines isolierenden Materials 7, wobei eine derartige Einbettung unter Bezugnahme auf Fig. 2, insbesondere Fig. 2e und 2f nachfolgend im Detail näher beschrieben werden wird.

Für eine Verbesserung der Haftung kann hiebei das isolierende Material 1 von einem eine Haftung insbesondere zwischen der leitenden bzw. leitfähigen Schicht 2 und dem isolierenden Material 7 zur Einbettung des elektronischen Bauteils 4 unterstützenden Material gebildet sein, wobei eine derartige, eine Anhaftung zwischen den einzelnen Schichten verbessernde Schicht bzw. Lage 1 beispielsweise von einer metallorganischen Schicht oder einer Harzschicht oder dgl. gebildet ist.

Nach der erfolgten Ummantelung bzw. Einbettung des Bauteils 4 durch das isolierende Material 7 wird die Trägerschicht 3 ausgehend von dem in Fig. 1c dargestellten Verfahrensschritt entsprechend dem Verfahrensschritt von Fig. 1d entfernt, so daß derart die durch die Träger- bzw. Schutzschicht 3 geschützte leitende bzw. leitfähige Schicht 2 freigelegt wird.

Für eine nachfolgende Kontaktierung der Kontakte 6 des elektronischen Bauteils 4 erfolgt gemäß dem in Fig. 1e dargestellten Verfahrensschritt eine Ausbildung von Löchern bzw. Durchbrechungen 8 in der leitenden Schicht 2 entsprechend der Position der Kontakte 6 des elektronischen Bauteils 4, wobei zur Herstellung der Löcher bzw. Durchbrechungen 8 schematisch ein Laserstrahl 9 angedeutet ist.

Der Laserstrahl 9 zur Ausbildung der Löcher bzw. Durchbrechungen 8 in der leitenden bzw. leitfähigen Schicht 2 wird beispielsweise von einem UV-Laser gebildet.

Nachfolgend auf die Herstellung der Löcher bzw. Durchbrechungen 8 in der leitenden bzw. leitfähigen Schicht 2 erfolgt auch eine Ausbildung der Löcher bzw. Durchbrechungen 11 entsprechend der Position der Kontakte 6 des elektronischen Bauteils 4 auch in der isolierenden Schicht 1 sowie in gegebenenfalls bestehenden Restschichten des Klebers 5 entsprechend dem Schritt von Fig. 1f. Zur Herstellung dieser Löcher bzw. Durchbrechungen 11 in der isolierenden Schicht 1 sowie gegebenenfalls in verbleibenden Restschichten des Klebers 5 wird beispielsweise ein vom Laser 9 verschiedener Laser 12 eingesetzt, wobei der Laser 12 zur Erzielung entsprechend großer Bearbeitungsgeschwindigkeiten sowie zur gleichzeitigen Vermeidung einer Beschädigung der freizulegenden Kontakte 6 des elektronischen Bauteils 4 beispielsweise von einem CO₂-Laser gebildet wird.

Aus Fig. 1f ist darüber hinaus ersichtlich, daß die Abmessungen des Laserstrahls 12 die Größe bzw. Abmessungen des Lochs bzw. der Durchbrechung 8 in der leitenden Schicht 2 übersteigen, wodurch unter entsprechend vereinfachter Positionierung des Laserstrahls 12 die Öffnungen bzw. Durchbrechungen 11 in der isolierenden Schicht 1 als auch in der verbleibenden Kleberschicht 5 hergestellt werden können. Es kann somit auf aufwendige und komplizierte Justierungen des Laserstrahls 12 relativ zu den bereits hergestellten Löchern bzw. Durchbrechungen 8 in der leitenden Schicht 2 verzichtet werden bzw. der Aufwand für ein Justieren entsprechend verringert werden.

Nach der Herstellung der Löcher bzw. Durchbrechungen 8 sowie 11 sowohl in der leitenden Schicht 2 als auch in der isolierenden Schicht 1 bzw. der verbleibenden Kleberschicht 5 erfolgt, wie dies in Fig. 1g angedeutet ist, eine Kontaktierung der Kontakte 6 mit der leitenden Schicht 2 durch Aufbringung einer weiteren leitenden Schicht 13 zumindest im Bereich der Löcher bzw. Durchbrechungen 8 und 11.

Darüber hinaus ist in Fig. 1g angedeutet, daß auch an der von der leitenden Schicht 2 abgewandten Seite eine zusätzliche leitende Schicht 14 angeordnet bzw. vorgesehen wird.

Zur Entfernung des isolierenden Materials 1 sowie gegebenenfalls von Resten des Klebers 5 zur Herstellung der Löcher bzw. Durchbrechungen 11 in der isolierenden Schicht 1 wird bei Vorsehen einer vergleichsweise dünnen isolierenden Schicht 1 und/oder einfach zu entfernenden isolierenden Materials bzw. einer Kleberschicht 5 mit geringem Füllstoffgehalt ein CO₂-Laser mit folgenden Parametern entsprechend Beispiel 1 eingesetzt.

### Beispiel 1

dünne isolierende Schicht (15-30 µm) und/oder Kleber mit geringem Füllstoffgehalt Gepulster CO₂-Laser
Leistung: 3 Watt
Strahldurchmesser: 180 µm
Pulsdauer: 6 µs
Anzahl der Pulse: 13
Lochdurchmesser: 75 µm

Unter Berücksichtigung der oben angegebenen Parameter der Leistung des eingesetzten CO₂-Lasers 12 ergibt sich darüber hinaus, daß durch die im Verfahrensschritt gemäß Fig. 1e hergestellten Löcher bzw. Durchbrechungen 8 durch den Laserstrahl 9 eine entsprechende Abdeckung der dahinterliegenden, isolierenden Schicht 1 zur Bereitstellung von entsprechend den Kontakten 6 konturierten Löchern 11 zur Verfügung gestellt wird.

Bei Vorsehen einer größeren Dicke für die isolierende Schicht 1 und/oder eines Klebers 5 mit einem hohen Füllstoffgehalt und/oder zur Herstellung größerer Löcher bzw. Durchbrechungen 11 kann ein CO₂-Laser mit entsprechend höherer Leistung gemäß dem nachfolgenden Beispiel 2 zum Einsatz gelangen.

### Beispiel 2

dicke isolierende Schicht (30 - 50 pm) und/oder Kleber mit hohem Füllstoffgehalt Gepulster CO₂-Laser
Leistung: 4 Watt
Strahldurchmesser: 280 µm
Pulsdauer: 8 µs
Anzahl der Pulse: 13
Lochdurchmesser: 120 µm

Derart können auch große Löcher bzw. Durchbrechungen 11 in einer entsprechend kurzen Zeitdauer hergestellt werden.

Nach der Herstellung bzw. Ausbildung der weiteren leitenden Schicht 13 zur Kontaktierung der Kontakte 6 des integrierten bzw. aufgenommenen Bauteils 4 ist im Rahmen eines subtraktiven Verfahrens in Fig. 1h angedeutet, daß für eine weitere Bearbeitung bzw. Strukturierung sowohl der leitenden Schicht 2 als auch gegebenenfalls der zusätzlichen leitenden Schicht 13 ein Photoresist 28 aufgebracht wird.

Entsprechend der Aufbringung des Photoresists 28 erfolgt in einem weiteren Verfahrensschritt gemäß Fig. 1i beispielsweise durch ein Ätzverfahren eine Ausbildung einer Strukturierung in der leitenden Schicht 2 durch eine Herstellung von Durchbrechungen bzw. Löchern 29 in der leitenden Schicht in vom Photoresist 28 nicht abgedeckten Bereichen.

Die fertiggestellte Strukturierung wird durch eine Entfernung des Photoresists 28 zur Verfügung gestellt, wie dies in Fig. 1j angedeutet ist.

Bei der in Fig. 2 dargestellten Verfahrensführung werden für gleiche Bauteile bzw. Elemente die Bezugszeichen der Fig. 1 beibehalten.

So wird gemäß dem in Fig. 2a dargestellten Verfahrensschritt wiederum ein Laminat 10 zur Verfügung gestellt, wobei eine isolierende bzw. nicht-leitende Schicht 1, eine leitende bzw. leitfähige Schicht 2 sowie eine Träger- bzw. Schutzschicht 3 vorgesehen sind.

Zur Ausrichtung bzw. Registrierung des in weiterer Folge festzulegenden elektronischen Bauteils 4 sind in dem in Fig. 2b dargestellten Verfahrensschritt zusätzlich hergestellte Markierungen 15 angedeutet, welche sowohl die isolierende Schicht 1 als auch die leitende bzw. leitfähige Schicht 2 durchdringen.

In dem in Fig. 2c dargestellten Verfahrensschritt erfolgt eine Aufbringung eines wiederum mit 5 bezeichneten Klebers, worauf anschließend in dem in Fig. 2d dargestellten Verfahrensschritt ein wiederum mit 4 bezeichneter, elektronischer Bauteil unter Vermittlung des Klebers 5 an dem Laminat 10 festgelegt wird.

Im Gegensatz zur der Ausführungsform gemäß Fig. 1, wonach der Kleber 5 lediglich über eine Fläche bzw. einen Bereich entsprechend den Abmessungen des festzulegenden elektronischen Bauteils 4 angeordnet bzw. vorgesehen wird, wird bei der in Fig. 2 dargestellten Ausführungsform eine die Abmessungen des festzulegenden elektronischen Bauteils 4 übersteigende Fläche mit dem Kleber 5 versehen. Die Registrierung bzw. Ausrichtung sowohl der Aufbringung des Klebers 5 als auch der Festlegung des Bauteils 4 erfolgt erfindungsgemäß relativ zu der Markierung 15.

In dem in Fig. 2e dargestellten Verfahrensschritt ist ersichtlich, daß für eine Ummantelung bzw. Einbettung des elektronischen Bauteils 4, wie es bei der vorangehenden Ausführungsform in Fig. 1c angedeutet wurde, eine Mehrzahl von mit 16 und 17 bezeichneten Schichten bzw. Lagen aus einem isolierenden Material, wie beispielsweise Prepreg-Folien, welche wenigstens teilweise entsprechend den Abmessungen des an dem Laminat 10 festgelegten Bauteils 4 konfiguriert sind, eingesetzt wird, wobei nach der in Fig. 2e angedeuteten Positionierung der einzelnen Lagen ein Laminier- bzw. Preßvorgang vorgenommen wird, so daß das in Fig. 2f dargestellte Verbundelement erhältlich ist, in welchem der elektronische Bauteil 4 vollständig von dem miteinander laminierten bzw. verpreßten und insgesamt isolierenden Material 18 umgeben ist.

Ähnlich wie bei den Ausführungen gemäß Fig. 1 erfolgt bei dem in Fig. 2f dargestellten Verfahrensschritt eine Entfernung der Schutz- bzw. Trägerschicht 3, so daß die leitfähige Schicht 2 freigelegt wird. Darüber hinaus ist bei dem in Fig. 2f dargestellten Verfahrensschritt ersichtlich, daß an der von der leitenden Schicht 2 abgewandten 2 Oberfläche für eine weitere Strukturierung bzw. einen weiteren Aufbau der herzustellenden Leiterplatte eine mit 19 bezeichnete leitende Schicht aufgebracht wird.

Bei dem in Fig. 2g dargestellten Verfahrensschritt erfolgt ähnlich wie bei dem in Fig. 1e dargestellten Verfahrensschritt eine Herstellung von wiederum mit 8 bezeichneten Löchern bzw. Durchbrechungen in der leitenden bzw. leitfähigen Schicht 2 entsprechend der Position der Kontakte 6 des elektronischen Bauteils 4.

Zusätzlich zu der Ausbildung von Löchern bzw. Durchbrechungen 8 in der leitenden bzw. leitfähigen Schicht 2 erfolgt, wie dies in dem Verfahrensschritt gemäß Fig. 2h dargestellt ist, die Ausbildung einer weiteren Durchbrechung 20 in der leitenden Schicht 2, wobei bei der in Fig. 2h dargestellten Ausführungsform diese zusätzliche Durchbrechung bzw. Bohrung 20 erfindungsgemäß relativ zu einer der Markierungen 15, und insbesondere im Bereich bzw. an der Position einer der Markierungen 15 ausgebildet wird.

Die Ausbildung der Durchbrechungen bzw. Löcher 8 entsprechend den Kontakten 6 des elektronischen Bauteils 4 als auch der zusätzlichen Öffnung bzw. Durchbrechung 20 erfolgt beispielsweise wiederum durch einen UV-Laser, wie dies im Zusammenhang mit Fig. 1 beschrieben wurde.

Nachfolgend erfolgt ähnlich wie bei der vorangehenden Ausführungsform entsprechend dem in Fig. 2i dargestellten Verfahrensschritt wiederum eine Ausbildung der Durchbrechungen 11 zur Freilegung der Kontakte 6 des elektronischen Bauteils 4. Neben der Ausbildung der Durchbrechungen bzw. Löcher 11 in der isolierenden Schicht 1 erfolgt entsprechend der Ausbildung bzw. Positionierung der zusätzlichen Durchbrechung 20 in der leitenden Schicht 2 auch eine Ausbildung einer zusätzlichen Durchbrechung 21 in dem isolierenden Material 18, in welchem der elektronische Bauteil 4 eingebettet ist.

Die Herstellung der Durchbrechung bzw. Löcher 11 in der isolierenden Schicht 1 zur Freilegung der Kontakte 6 des elektronischen Bauteils 4 kann ähnlich wie bei der vorausgehenden Ausführungsform wiederum durch Einsatz eines CO₂-Lasers in rascher und günstiger Weise erfolgen. Durch Auswahl der Abmessungen des CO₂-Lasers kann bei entsprechender Größe desselben auch die eine vergleichsweise größere Abmessung aufweisende zusätzliche Durchbrechung 21 in einem gemeinsamen Arbeitsschritt hergestellt werden.

In Fig. 2j ist darüber hinaus angedeutet, daß nach der Herstellung der Durchbrechungen 11 bzw. 21 anstelle der in Fig. 1g angedeuteten Ausbildung einer leitenden Schicht 13 unmittelbar ein Aufbau einer zusätzlichen leitenden Schicht 22 zur Kontaktierung der Kontakte 6 des elektronischen Bauteils 4 als auch unter Ausbildung einer Durchkontaktierung 23 in dem Bereich der hergestellten zusätzlichen Durchbrechung 21 eine Kontaktierung mit einer an der gegenüberliegenden Seite zusätzlich angeordneten leitenden Schicht 24 erfolgt. Diese zusätzliche leitende Schicht 22 bzw. 24 sowie die vorab hergestellte leitende Schicht 19 werden einer zusätzlichen Strukturierung unterworfen, wie dies durch Ausnehmungen bzw. Durchbrechungen 25 angedeutet ist.

Die erfindungsgemäße Ausbildung der wenigstens einen zusätzlichen Durchbrechung 20 oder 21 sowohl in der leitenden Schicht 2 als auch in der isolierenden Schicht 1 sowie dem isolierenden Material 18 der Ummantelung erlaubt eine Anordnung bzw. Ausbildung einer derartigen Durchkontaktierung 23 nicht nur im Rahmen der Herstellung einer Kontaktierung mit den Kontakten 6 des elektronischen Bauteils 4, sondern auch unter Einhaltung geringerer Abstände zu dem elektronischen Bauteil 4, als dies nach einer Fertigstellung der Leiterplatte in nachfolgenden getrennten Verfahrensschritten bei einer insbesondere mechanischen Herstellung derartiger Löcher bzw. Durchbrechungen zur Herstellung einer Durchkontaktierung möglich wäre.

Anstelle der Heranziehung der wenigstens einen zusätzlichen Durchbrechung 20 sowie 21 sowohl in der leitenden Schicht 2 als auch in der isolierenden Schicht 1 für eine nachfolgende Ausbildung einer Durchkontaktierung kann eine derartige zusätzliche Durchbrechung 20 bzw. 21 auch zur Bereitstellung bzw. Begrenzung der Konturen eines Leiterplattenelements herangezogen werden, in welchem der elektronische Bauteil 4 integriert ist, wie dies schematisch in Fig. 6 angedeutet ist.

Durch Ausbildung der zusätzlichen Durchbrechungen 20 oder 21 in einem im wesentlichen gemeinsamen Arbeitsschritt mit der Herstellung der Durchbrechungen bzw. Löcher 8 bzw. 11 sowohl in der leitenden Schicht 2 als auch in der isolierenden Schicht 1 kann auch bei der Herstellung der Kontur der Leiterplatte eine entsprechende Erhöhung der Präzision unter Einhaltung verringerter Prozeßtoleranzen und somit insgesamt eine Miniaturisierung des herzustellenden Leiterplattenelements erzielt werden.

Bei der schematischen Darstellung gemäß Fig. 6 ist angedeutet, daß zur Herstellung der Kontur des Leiterplattenelements, in welches der Bauteil 4 eingebettet ist, die zusätzlichen Durchbrechungen 20 bzw. 21 mit Ausnahme von Sollbruchstellen 33 für eine vorübergehende Verankerung bzw. Festlegung im wesentlichen eine durchgehende Linie darstellen, welche den elektronischen Bauteil 4 umgibt. Zur Vereinfachung der Darstellung von Fig. 6 sind hierbei keinerlei Strukturierungen der leitenden Schicht 2 dargestellt bzw. angedeutet. Durch Ausbildung der Kontur durch Herstellung der wenigstens einen weiteren Durchbrechung 20 bzw. 21 kann unter Verbesserung der Ausnutzung der zur Verfügung stehenden Fläche eine weitere Miniaturisierung eines derartigen Leiterplattenelements 31 erzielt werden.

Auch bei der in Fig. 2 dargestellten Ausführungsform kann das isolierende Material 1 von einem insbesondere eine Haftung zwischen der leitenden Schicht 2 und dem den Bauteil 4 umgebenden Material 8 bzw. den einzelnen Schichten bzw. Lagen 16 und 17 unterstützenden bzw. fördernden Material gebildet sein.

In Fig. 3 ist in gegenüber den vorangehenden Figuren vergrößertem Maßstab eine abgewandelte Ausführungsform eines wiederum mit 10 bezeichneten Laminats dargestellt, wobei neben der isolierenden Schicht 1, der leitenden bzw. leitfähigen Schicht 2 sowie einer Schutzschicht 3 eine zusätzliche Trägerschicht 26 vorgesehen ist. Die Trägerschicht 26 ist beispielsweise von einem metallischen Blech gebildet, so daß eine derartige Trägerschicht bzw. ein derartiges metallisches Blech 26 beispielsweise während des in Fig. 2e und 2f dargestellten Laminier- bzw. Preßvorgangs unmittelbar als Preßblech eingesetzt werden kann, wobei ein derartiges Trägerblech 26 eine entsprechend ausreichend hohe mechanische Festigkeit aufweist. Derart kann auch ein entsprechender Schutz insbesondere der leitenden Schicht 2, welche gegebenenfalls eine vergleichsweise geringe Dicke von 50 µm oder weniger aufweist, insbesondere während Bestückungsvorgängen vor der Herstellung der Löcher bzw. Durchbrechungen 8 bzw. 11 zur Kontaktierung der Kontakte 6 des elektronischen Bauteils 4 zur Verfügung gestellt werden.

Bei der in Fig. 4 dargestellten abgewandelten Ausführungsform entsprechen die in Fig. 4a bis 4d dargestellten Schritte den in Fig. 1a bis 1d dargestellten Schritten, so daß eine neuerliche Beschreibung dieser Schritte nicht vorgenommen wird. Das dargestellte Verfahren ist jedoch nicht Teil der Erfindung.

Bei dem in Fig. 4e dargestellten Verfahrensschritt erfolgt im Rahmen einer Vorbehandlung der leitenden bzw. leitfähigen Schicht 2 nach Entfernung der Träger- bzw. Schutzschicht 3 eine Aufbringung einer Kupferoxidschicht 27, welche gegebenenfalls durch eine weitere organische oder metallorganische Schicht abgedeckt ist, welche jedoch nicht getrennt dargestellt ist.

Nach einer derartigen Vorbehandlung bzw. Aufbringung einer zusätzlichen Schicht 27 auf der leitenden bzw. leitfähigen Schicht 2 erfolgt eine Ausbildung von Löchern bzw. Durchbrechungen 8 und 11 entsprechend den Kontakten 6 des elektronischen Bauteils 4 sowohl in der leitenden Schicht 2 sowie der darauf angeordneten zusätzlichen Schicht 27 als auch der isolierenden Schicht 1 in einem gemeinsamen Arbeitsschritt, wobei hiefür, wie dies in Fig. 4f dargestellt ist, ein Laser entsprechend dem schematischen CO₂-Laser 32 zum Einsatz gelangt.

Durch Vorsehen der zusätzlichen bzw. Vorbehandlungsschicht 27 auf der leitenden bzw. leitfähigen Schicht 2 kann somit unter Einsatz eines CO₂-Lasers 32 eine entsprechende Ausbildung der Durchbrechungen bzw. Löcher 8 und 11 entsprechend den Kontakten 6 des elektronischen Bauteils 4 in einem gemeinsamen Arbeitsschritt erfolgen.

Zur Bereitstellung der auch für die Herstellung der Löcher bzw. Durchbrechungen 8 in der leitenden Schicht erforderlichen Leistung bei Verwendung eines CO₂-Lasers 32 wird eine gegenüber dem Einsatz eines CO₂-Lasers 12 lediglich zur Entfernung der isolierenden Schicht, wie sie unter Bezugnahme auf Fig. 1 im Detail erörtert wurde, eine erhöhte Pulsdauer von wenigstens 200 ps, beispielsweise etwa 285 µs vorgeschlagen. Durch Einsatz einer derart verlängerten Pulsdauer kann mit einer verringerten Anzahl von Pulsen von beispielsweise 5 und insbesondere 2 Pulsen das Auslangen gefunden werden, um die Löcher bzw. Durchbrechungen 8 und 11 sowohl in der leitenden Schicht 2 als auch der daran angebrachten Vorbehandlungsschicht 27 und der isolierenden Schicht 1 zur Freilegung der Kontakte 6 des Bauteils 4 zur Verfügung zu stellen.

Nach einer derartigen Herstellung der Löcher bzw. Durchbrechungen 8 sowie 11 in der leitenden Schicht 2 als auch in der isolierenden Schicht 1 erfolgt eine Entfernung der zusätzlichen bzw. Vorbehandlungsschicht 27 beispielsweise durch einen Ätzschritt, wie dies in Fig. 4g angedeutet ist.

Die Ausbildung einer zusätzlichen leitenden bzw. leitfähigen Schicht 13 entsprechend der Darstellung von Fig. 4h entspricht wiederum dem in Fig. 1g dargestellten Verfahrensschritt.

Nachfolgend kann eine weitere Strukturierung vorgenommen werden, wie dies beispielsweise in Fig. 1h bis 1j angedeutet ist.

Für eine nachfolgende Strukturierung wird entweder eine eine entsprechende Dicke aufweisende leitende Schicht 2 des Laminats 10 eingesetzt oder es kann, wobei dies zur Vereinfachung nicht näher dargestellt ist, zur Erzielung der erforderlichen Schichtdicke für die herzustellende leitende bzw. leitfähige Struktur, beispielsweise in Form von Leiterbahnen auf der leitenden bzw. leitfähigen Schicht 2 des Laminats 10, eine entsprechende zusätzliche leitende bzw. leitfähige Schicht aufgebracht bzw. ausgebildet werden.

Bei der Darstellung gemäß Fig. 5 entsprechen die Verfahrensschritte gemäß den Fig. 5a bis 5f wiederum den Schritten gemäß Fig. 1a bis 1f, so daß eine detaillierte Beschreibung derselben nicht neuerlich vorgenommen wird. Das dargestellte Verfahren ist jedoch nicht Teil der Erfindung.

Zur Herstellung einer Kontaktierung der Kontakte 6 des integrierten Bauteils 4 erfolgt ein chemisches Verkupfern, wie dies in Fig. 5g angedeutet ist, wobei eine derartige zusätzliche leitende Schicht zur Kontaktierung der Bauteile 6 des Bauteils 4 wiederum mit 13 bezeichnet wird.

In einem nachfolgenden Verfahrensschritt gemäß Fig. 5h erfolgt wiederum eine Aufbringung einer Maske in Form eines Photoresists 28, worauf gemäß dem in Fig. 5i dargestellten Verfahrensschritt beispielsweise Leiterzüge durch ein sogenanntes Plating im Rahmen eines semiadditiven Verfahrens hergestellt werden, wobei die Leiterzüge mit 30 angedeutet sind.

Entsprechend dem in Fig. 5j dargestellten Verfahrensschritt erfolgt eine Freilegung der Leiterzüge 30 durch ein Entfernen des Photoresists 28, so daß insgesamt eine Strukturierung erzielt wird, worauf anschließend in Übereinstimmung mit den Leiterzügen 30 gemäß dem in Fig. 5k dargestellten Verfahrensschritt beispielsweise durch ein Flash-Etching auch eine Entfernung von Teilbereichen der leitenden bzw. leitfähigen dünnen Kupferschicht 2 erfolgt, so daß insgesamt eine Strukturierung der von den Schichten 2 und 30 gebildeten leitenden bzw. leitfähigen Schicht zur Verfügung gestellt wird.

Auch bei den in Fig. 4 und 5 dargestellten abgewandelten Verfahren kann ebenso wie bei der Ausführungsform gemäß Fig. 2 zusätzlich zu der Kontaktierung des integrierten Bauteils wenigstens eine weitere Durchbrechung 20 bzw. 21 zur nachfolgenden Herstellung einer Durchkontaktierung 23 oder zur Bereitstellung der Kontur des Leiterplattenelements 31 zur Verfügung gestellt werden, wie dies unter Bezugnahme auf Fig. 2 sowie Fig. 6 im Detail erörtert worden ist.

## Patentansprüche

1. Verfahren zur Integration eines elektronischen Bauteils (4) in eine Leiterplatte, wobei auf einem wenigstens aus einer Träger- bzw.Schutzschicht (3), einer leitenden bzw. leitfähigen Schicht (2) und einer nicht-leitenden bzw. isolierenden Schicht (1) gebildeten Laminat der elektronische Bauteil (4) mit zu der isolierenden Schicht (1) gerichteten Kontakten (6) auf dieser festgelegt wird, nach der Festlegung des Bauteils (4) auf der isolierenden Schicht (1) die Träger- bzw. Schutzschicht (3), entfernt wird, so daß die leitende Schicht (2) freigelegt wird und Löcher bzw. Durchbrechungen (8, 11) in der leitenden Schicht (2) und in der isolierenden Schicht (2) entsprechend den Kontakten (6) des Bauteils (4) ausgebildet werden und anschließend eine Kontaktierung der Kontakte (6) mit der leitenden Schicht (2) erfolgt, **dadurch gekennzeichnet, dass** die Ausbildung der Löcher bzw. Durchbrechungen (8, 11) in der leitenden Schicht (2) und in der isolierenden Schicht (2) nach der Festlegung des Bauteils (4) in getrennten Verfahrensschritten vorgenommen wird, dass vor der Festlegung des Bauteils (4) an der isolierenden Schicht (1) wenigstens eine Markierung (15) zumindest in der isolierenden Schicht (1) für eine Registrierung bzw. Ausrichtung des Bauteils (4) auf der isolierenden Schicht (1) ausgebildet wird, dass die wenigstens eine Markierung (15) von einer sowohl die isolierende Schicht (1) als auch die leitende Schicht (2) durchdringenden Bohrung bzw. Durchbrechung gebildet wird, dass zusätzlich zur Ausbildung von Löchern bzw. Durchbrechungen (8) in der leitenden Schicht (2) und der nicht-leitenden Schicht (1) entsprechend den Kontakten (6) des Bauteils (4) wenigstens eine zusätzliche Durchbrechung (20, 21) außerhalb des Bereichs der Festlegung des Bauteils (4) an dem Laminat (10) zur Herstellung einer nachfolgenden Durchkontaktierung (23) und/oder zur Herstellung der Kontur eines Leiterplattenelements (31) ausgebildet wird, und dass die zusätzliche Durchbrechung (20, 21) in Bezug zu der vorab hergestellten Markierung (15) ausgebildet wird.

2. Verfahren nach Anspruch 1, **dadurch gekennzeichnet, dass** der elektronische Bauteil (4) nach dem Festlegen an der isolierenden Schicht (1) in an sich bekannter Weise von einem isolierenden Material (7, 16, 17, 18), insbesondere wenigstens einer Prepreg-Folie und/oder einem Harz umgeben bzw. ummantelt wird.

3. Verfahren nach Anspruch 2, **dadurch gekennzeichnet, dass** die Ummantelung (7, 18) des elektronischen Bauteils (4) durch einen Press- bzw. Laminiervorgang einer Mehrzahl von isolierenden Schichten (16, 17) vorgenommen wird.

4. Verfahren nach Anspruch 1, 2 oder 3, **dadurch gekennzeichnet, dass** der elektronische Bauteil (4) auf der isolierenden Schicht (1) in an sich bekannter Weise mittels eines Klebers (5) festgelegt wird.

5. Verfahren nach Anspruch 4, **dadurch gekennzeichnet, dass** ein thermisch leitendes bzw. leitfähiges Klebematerial, beispielsweise Kleber oder Klebestreifen (5) verwendet wird.

6. Verfahren nach einem der Ansprüche 1 bis 5, **dadurch gekennzeichnet, dass** die Löcher bzw. Durchbrechungen (8) in der leitenden Schicht (2) durch einen Bohrvorgang, insbesondere ein Laserbohren, oder einen Ätzvorgang ausgebildet werden.

7. Verfahren nach einem der Ansprüche 1 bis 6, **dadurch gekennzeichnet, dass** bei getrennter Ausbildung der Löcher bzw. Durchbrechungen (8) in der leitenden Schicht (2) ein UV-Laser verwendet wird.

8. Verfahren nach einem der Ansprüche 1 bis 7, **dadurch gekennzeichnet, dass** die Löcher bzw. Durchbrechungen (11) in der isolierenden Schicht (1) durch einen Laser, insbesondere einen CO₂-Laser (12, 32) ausgebildet werden.

9. Verfahren nach Anspruch 8, **dadurch gekennzeichnet, dass** bei der Ausbildung der Löcher bzw. Durchbrechungen (11) in der isolierenden Schicht (1) ein Laserstrahl (12) eingesetzt wird, dessen Abmessung bzw. Durchmesser die lichte Weite der Löcher bzw. Durchbrechungen (11) in der leitenden Schicht (2) übersteigt.

10. Verfahren nach einem der Ansprüche 1 bis 9, **dadurch gekennzeichnet, dass** zur Ausbildung der Durchbrechung (20, 21) für die Durchkontaktierung (23) und/oder Kontur der bzw. die für die Ausbildung der Durchbrechungen bzw. Löcher (8, 11) in der leitenden und isolierenden Schicht (1, 2) vorgesehene(n) Laserstrahl(en) (9, 12, 32) verwendet wird bzw. werden.

## Claims

1. A method for integrating an electronic component (4) into a printed circuit board, wherein, onto a laminate at least consisting of a carrier or support layer (3), a conducting or conductive layer (2) and a non-conducting or insulating layer (1), the electronic component (4) comprising contacts (6) oriented towards the insulating layer (1) is fixed thereto, once the component (4) has been fixed to the insulating layer (1), the carrier or protective layer (3) is removed, thereby exposing the conducting layer (2) and forming holes or perforations (8, 11) corresponding to the contacts (6) of the component (4) in the conducting layer (2) and in the insulating layer (1), and the contacts (6) are subsequently contacted with the conducting layer (2), **characterized in that** the formations of the holes or perforations (8, 11) in the conducting layer (2) and in the insulating layer (1) are performed in separate method steps after the fixation of the component (4), that prior to fixing the component (4) to the insulating layer (1) at least one marker (15) is formed at least in the insulating layer (1) for registering and aligning the component (4) on the insulating layer (1), that the at least one marker (15) is formed by a bore or perforation penetrating both the insulating layer (1) and the conducting layer (2), that in addition to forming holes or perforations (8) corresponding to the contacts (6) of the component (4) in the conducting layer (2) and in the non-conducting layer (1) at least one additional perforation (20, 21) is formed outside the region of the fixation of the component (4) to the laminate (10) for the formation of a subsequent feedthrough (23) and/or for the formation of the contour of a circuit board element (31), and that the additional perforation (20, 21) is formed relative to the previously produced marker (15).

2. A method according to claim 1, **characterized in that** the electronic component (4), once it has been fixed to the insulating layer (1), is surrounded or sheathed by an insulating material (7, 16, 17, 18), particularly at least one prepreg sheet and/or a resin, in a manner known per se.

3. A method according to claim 2, **characterized in that** the sheathing (7, 18) of the electronic component (4) is realized by a pressing or laminating procedure of a plurality of insulating layers (16, 17).

4. A method according to claim 1, 2 or 3, **characterized in that** the electronic component (4) is fixed to the insulating layer (1) in a manner known per se using an adhesive (5) .

5. A method according to claim 4, **characterized in that** a thermally conducting or conductive adhesive material, e.g. an adhesive or an adhesive tape (5), is used.

6. A method according to any one of claims 1 to 5, **characterized in that** the holes or perforations (8) in the conducting layer (2) are formed by a drilling procedure, particularly laser drilling, or an etching procedure.

7. A method according to any one of claims 1 to 6, **characterized in that** an UV laser is used when forming the holes or perforations (8) in the conducting layer (2) separately.

8. A method according to any one of claims 1 to 7, **characterized in that** the holes or perforations (11) in the insulating layer (1) are made by a laser, particularly a CO₂ laser (12, 32).

9. A method according to claim 8, **characterized in that** a laser beam (12) whose dimension or diameter exceeds the clear width of the holes or perforations (11) in the conducting layer (2) is used for forming the holes or perforations (11) in the insulating layer (1).

10. A method according to any one of claims 1 to 9, **characterized in that** the laser beam(s) (9, 12, 32) provided for forming the perforations or holes (8, 11) in the conducting and insulating layers (1, 2) is/are used for forming the perforation (20, 21) for the feedthrough (23) and/or contour.

## Revendications

1. Procédé d'intégration d'un composant électronique (4) dans une carte imprimée, dans lequel sur un stratifié formé au moins d'une couche de support ou de protection (3), d'une couche conductrice ou conductible (2) et d'une couche non conductrice ou isolante (1), le composant électronique (4) est fixé avec des contacts (6) dirigés vers la couche isolante (1) sur celle-ci, après la fixation du composant (4) sur la couche isolante (1), la couche de support ou de protection (3) est enlevée, de sorte que la couche conductrice (2) est dégagée et des trous ou passages (8, 11) sont réalisés dans la couche conductrice (2) et dans la couche isolante (2) en fonction des contacts (6) du composant (4) et ensuite a lieu une mise en contact des contacts (6) avec la couche conductrice (2), **caractérisé en ce que** la réalisation des trous ou passages (8, 11) dans la couche conductrice (2) et dans la couche isolante (2) est effectuée après la fixation du composant (4) dans des étapes de procédé séparées, qu'avant la fixation du composant (4) au niveau de la couche isolante (1), au moins un marquage (15) est réalisé au moins dans la couche isolante (1) pour un enregistrement ou une orientation du composant (4) sur la couche isolante (1), que l'au moins un marquage (15) est formé par un perçage ou passage traversant aussi bien la couche isolante (1) que la couche conductrice (2), qu'en plus de la réalisation de trous ou passages (8) dans la couche conductrice (2) et la couche non conductrice (1), au moins un passage (20, 21) supplémentaire est réalisé en fonction des contacts (6) du composant (4) à l'extérieur de la zone de la fixation du composant (4) au niveau du stratifié (10) pour la fabrication d'un via (23) suivant et/ou pour la fabrication du contour d'un élément de plaque imprimée (31), et que le passage (20, 21) supplémentaire est réalisé par rapport au marquage (15) fabriqué au préalable.

2. Procédé selon la revendication 1, **caractérisé en ce que** le composant électronique (4) est entouré ou enveloppé après la fixation au niveau de la couche isolante (1) de manière connue en soi d'un matériau isolant (7, 16, 17, 18), en particulier d'au moins une feuille pré-imprégnée et/ou d'une résine.

3. Procédé selon la revendication 2, **caractérisé en ce que** l'enveloppement (7, 18) du composant électronique (4) est effectué par une opération de compression ou de stratification d'une pluralité de couches isolantes (16, 17).

4. Procédé selon la revendication 1, 2 ou 3, **caractérisé en ce que** le composant électronique (4) est fixé sur la couche isolante (1) de manière connue en soi au moyen d'un adhésif (5).

5. Procédé selon la revendication 4, **caractérisé en ce qu'**un matériau adhésif thermoconducteur ou thermoconductible, par exemple un adhésif ou des bandes adhésives (5), est utilisé.

6. Procédé selon l'une quelconque des revendications 1 à 5, **caractérisé en ce que** les trous ou passages (8) sont réalisés dans la couche conductrice (2) par une opération de perçage, en particulier un perçage au laser, ou une opération de gravure.

7. Procédé selon l'une quelconque des revendications 1 à 6, **caractérisé en ce que** lors de la réalisation séparée des trous ou passages (8) dans la couche conductrice (2), un laser UV est utilisé.

8. Procédé selon l'une quelconque des revendications 1 à 7, **caractérisé en ce que** les trous ou passages (11) sont réalisés dans la couche isolante (1) par un laser, en particulier un laser CO₂ (12, 32).

9. Procédé selon la revendication 8, **caractérisé en ce que** lors de la réalisation des trous ou passages (11) dans la couche isolante (1), un faisceau laser (12) est utilisé, dont le dimensionnement ou diamètre dépasse la largeur intérieure des trous ou passages (11) dans la couche conductrice (2).

10. Procédé selon l'une quelconque des revendications 1 à 9, **caractérisé en ce que** le ou les faisceau(x) laser (9, 12, 32) prévu(s) pour la réalisation des passages ou trous (8, 11) dans la couche conductrice et isolante (1, 2) est ou sont utilisé (s) pour la réalisation du passage (20, 21) pour le via (23) et/ou le contour.
